# EUROPEAN PATENT APPLICATION

(11) **EP 4 539 633 A1**
(43) Date of publication of application: **16.04.2025**
(21) Application number: 24193569.1
(22) Date of filing: 08.08.2024
(51) Int. Cl.: H10D 62/10, H10D 30/01, H10D 30/43, H10D 30/00, H10D 62/17, H10D 30/69

(54) **INTEGRATED CIRCUIT DEVICE INCLUDING A PFET WITH A SILICON GERMANIUM CLADDED CHANNEL AND METHODS OF FORMING THE SAME**

(30) Priority: 10.10.2023 US 202363589113 P; 04.04.2024 US 202418626520
(71) Applicant: Samsung Electronics Co., Ltd, Suwon-si, Gyeonggi-do 16677 (KR)
(72) Inventor: YANG, Myung, San Jose, CA, 95134 (US); SEO, Kang-ill, San Jose, CA, 95134 (US); YUN, Seungchan, San Jose, CA, 95134 (US)
(74) Representative: Kuhnen & Wacker Patent- und Rechtsanwaltsbüro PartG mbB

(57) **Abstract**

An integrated circuit device includes a p-type field effect transistor that includes a strained channel, the strained channel comprising a silicon channel (110) and silicon germanium cladding layers (150) on opposing surfaces thereof, the silicon germanium cladding layers (150) abutting the silicon channel (110) without being grown therefrom.

## Description

### BACKGROUND

The present disclosure generally relates to the field of integrated circuit devices and, more particularly, to integrated circuit devices including stacked transistors.

The size of transistors has continued to decrease to allow the continued scale down of logic elements. And planar-structured transistors have evolved into gate all around structures, such as finFET and NMCFET, the technology to concentrate more transistors within the same area has continued to develop. Three-dimensional device structures may allow higher concentrations of transistors within the same area. Gate metal processes may, however, be complicated because three dimensional devices may have high aspect ratios due to the vertical positioning of the nFET and pFET transistors.

### SUMMARY

An integrated circuit device, according to some embodiments, includes a p-type field effect transistor that includes a strained channel, the strained channel comprising a silicon channel and silicon germanium cladding layers on opposing surfaces thereof, the silicon germanium cladding layers abutting the silicon channel without being grown therefrom. In some embodiments, the integrated circuit device may further comprise: middle dielectric isolation spacers on opposite ends of each of the opposing surfaces of the silicon channel, wherein the silicon germanium cladding layers are between the middle dielectric isolation spacers on the opposing surfaces of the silicon channel, respectively. In some embodiments, the middle dielectric isolation spacers may comprise: nanopourous silica, hydrogensilsesquioxanes, HSQ, teflon-AF, polytetrafluoethylene or PTFE, silicon oxyflouride, FSG, silicon oxide, silicon oxynitride, silicon nitride, and/or silicon carbonitride. In some embodiments, the silicon channel may include a silicon germanium layer therein. In some embodiments, a percent composition of the silicon germanium layer in the silicon channel may be greater than 20%. In some embodiments, the P-type field effect transistor may be one of a plurality of P-type field effect transistors arranged in a stack, each of the plurality of P-type field effect transistors including the strained channel, the strained channel comprising the silicon channel and the silicon germanium cladding layers on the opposing surfaces thereof, the silicon germanium cladding layers abutting the silicon channels without being grown therefrom. In some embodiments, the integrated circuit device may further comprise: middle dielectric isolation spacers on opposite ends of each of the opposing surfaces of each of the silicon channels, wherein the silicon germanium cladding layers are between the middle dielectric isolation spacers on the opposing surfaces, respectively, of each of the silicon channels. In some embodiments, the integrated circuit device may further comprise: inner spacers between adjacent ones of the silicon channels in the stack and that contact the middle dielectric isolation spacers on the respective ones of the silicon channels. In some embodiments, the integrated circuit device may further comprise: a middle dielectric isolation layer that is between a substrate and the stack. In some embodiments, the middle dielectric isolation layer may comprise: nanopourous silica, hydrogensilsesquioxanes (HSQ), teflon-AF (polytetrafluoethylene or PTFE), silicon oxyflouride (FSG), silicon oxide, silicon oxynitride, silicon nitride, and/or silicon carbonitride. In some embodiments, the silicon germanium cladding layers may wrap around each silicon channel.

A method, according to some embodiments, includes forming p-type field effect transistor a stack comprising a pair of silicon germanium layers with a silicon channel therebetween, the silicon channel being spaced apart from the pair of silicon germanium layers; and epitaxially growing silicon germanium on respective surfaces of each of the silicon germanium layers adjacent the silicon channel, such that each of the silicon germanium layers abuts the silicon channel on opposing surfaces thereof. In some embodiments, the method may further comprise: removing portions of each of the silicon germanium layers to leave silicon germanium cladding layers on the opposing surfaces of the silicon channel, respectively. In some embodiments, forming the p-type field effect transistor stack may comprise: forming a stack comprising alternating silicon germanium layers and silicon channels with sacrificial silicon germanium layers separating adjacent ones of the silicon germanium layers and silicon channels, the alternating silicon germanium layers and silicon channels comprising the pair of silicon germanium layers and the silicon channel; and removing the sacrificial silicon germanium layers (115; 315), wherein each of the sacrificial silicon germanium layers has a percent composition of germanium of at least 55%. In some embodiments, the method may further comprise: forming middle dielectric isolation spacers on opposite ends of each of the opposing surfaces of each of the silicon channels, wherein the middle dielectric isolation spacers comprise: nanopourous silica, hydrogensilsesquioxanes, HSQ, teflon-AF, polytetrafluoethylene or PTFE, silicon oxyflouride (FSG), silicon oxide, silicon oxynitride, silicon nitride, and/or silicon carbonitride. In some embodiments, the method may further comprise: forming inner spacers between adjacent ones of the silicon channels in the stack and that contact the middle dielectric isolation spacers on the respective ones of the silicon channels, wherein the inner spacers comprise silicon oxide, silicon oxynitride, silicon nitride, and/or silicon carbonitride. In some embodiments, the method epitaxially growing the silicon germanium on the respective surfaces of each of the silicon germanium layers may comprise: epitaxially growing silicon germanium on respective surfaces of each of the silicon germanium layers adjacent each of the silicon channels, such that each of the silicon germanium layers abuts adjacent ones of the silicon channels; and removing portions of each of the silicon germanium layers to leave silicon germanium cladding layers on the opposing surfaces, respectively, of each of the silicon channels, wherein the silicon germanium cladding layers are between the middle dielectric isolation spacers on the opposing surfaces, respectively, of each of the silicon channels. In some embodiments, forming the stack comprising the alternating silicon germanium layers and silicon channels with the sacrificial silicon germanium layers separating adjacent ones of the silicon germanium layers and silicon channels may further comprise: forming one of the sacrificial silicon germanium layers between the stack and a substrate. In some embodiments, the method may further comprise: forming a middle dielectric isolation layer between stack and the substrate after removing the sacrificial silicon germanium layers, wherein the middle dielectric isolation layer comprises: nanopourous Silica, hydrogensilsesquioxanes (HSQ), teflon-AF (polytetrafluoethylene or PTFE), silicon oxyflouride (FSG). silicon oxide, silicon oxynitride, silicon nitride, and/or silicon carbonitride. In some embodiments each silicon channel may include a silicon germanium layer therein.

### BRIEF DESCRIPTION OF THE DRAWINGS

FIGS. 1A - 1H are cross-sectional views that illustrate methods of forming an integrated circuit device according to some embodiments of the disclosure;
FIG. 2 is a flowchart that illustrates operations associated with the cross-sectional views of FIGS. 1A - 1G according to some embodiments of the disclosure;
FIGS. 3A - 3G are cross-sectional views that illustrate methods of forming an integrated circuit device according to some embodiments of the disclosure;
FIG. 4 is a flowchart that illustrates operations associated with the cross-sectional views of FIGS. 3A - 3G according to some embodiments of the disclosure; and
FIG. 5 is a perspective view of a gate all around finFET structure including multiple field effect transistors with strained channels, respectively, according to some embodiments of the disclosure.

### DETAILED DESCRIPTION

Some embodiments stem from a realization that as CMOS devices have scaled smaller, new materials have been considered as replacement for silicon. Silicon germanium has been considered as a new material for PMOS devices. Germanium provides the highest hole mobility (1900 cm²/V/s) among all group IV or III-V class of materials. Because it is generally difficult to fabricate a good insulator using germanium, silicon germanium may be used as an alternative option. Germanium has a larger lattice constant than silicon (~4.2% mismatch), which leads to silicon germanium being compressively strained when on silicon. A strained silicon germanium channel, e.g., silicon germanium on silicon, may increase hole mobility in PMOS devices. Some embodiments of the inventive concept may provide an integrated circuit device including one or more p-type field effect transistors where each of the transistors includes a strained channel comprising a silicon channel and silicon germanium cladding layers on opposing surfaces thereof. The silicon germanium cladding layers abut the silicon channel without being grown therefrom. According to some embodiments, the silicon germanium cladding layers can be epitaxially grown from sacrificial silicon germanium layers that are adjacent to the silicon channel. As a result, the three-dimensional integrated circuit device can be fabricated without increasing fabrication processing complexity.

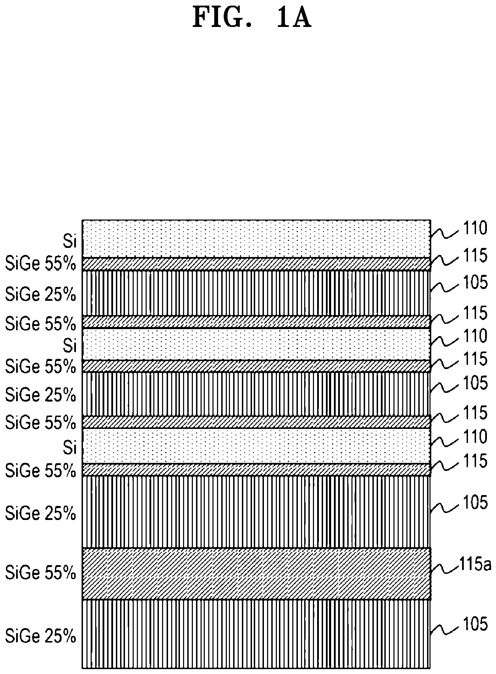

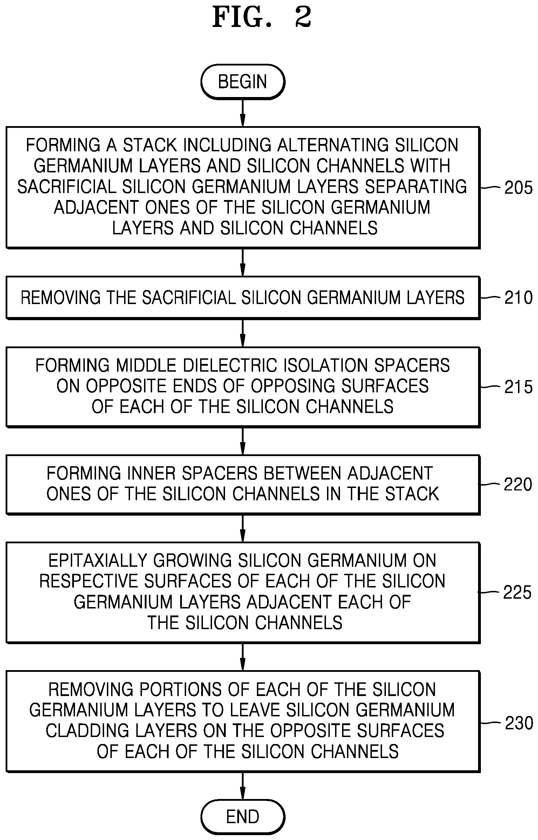

FIGS. 1A - 1G and FIG. 2 illustrate an integrated circuit device including a p-type field effect transistor (PFET) with a silicon germanium cladded channel and methods of forming the same according to some embodiments of the disclosure. Referring to FIGS. 1A and FIG. 2, operations begin at block 205 where a stack is formed including alternating silicon germanium layers 105 and silicon channels 110, with sacrificial silicon germanium layers 115 separating adjacent ones of the silicon germanium layers 105 from the silicon channels 110. In some embodiments, the percent composition of germanium in each of the silicon germanium layers 105 is greater than about 20%. In other embodiments, the percent composition of germanium in each of the silicon germanium layers 105 is about 25%. The sacrificial silicon germanium layers 115 may have a percent composition of germanium of about 55%. One of the sacrificial silicon germanium layers 115a may be between two of the silicon germanium layers 105.

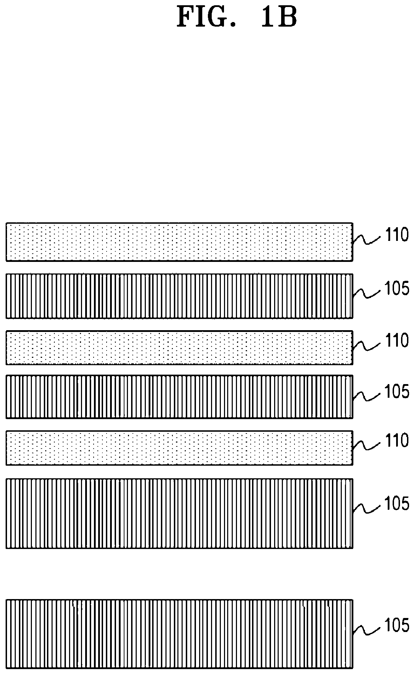

Referring to FIG. 1B and FIG. 2, the sacrificial silicon germanium layers 115 and 115a are selectively removed at block (step) 210. The sacrificial silicon germanium layers 115 may be selectively removed using an etchant having an etching selectivity for the sacrificial silicon germanium layers 115, 115a relative to the other silicon channels 110 and silicon germanium layers 105. In accordance with different embodiments of the disclosure, the etching may be performed using a wet etching and/or a dry etching process.

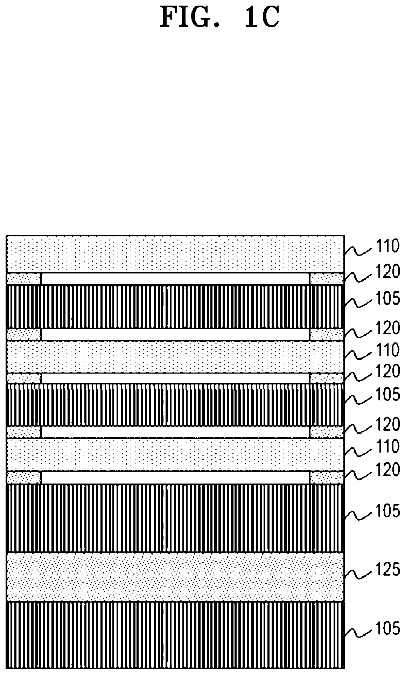

Referring to FIG. 1C and FIG. 2, middle dielectric isolation spacers 120 are formed on opposite ends of opposing surfaces of each of the silicon channels 110 at block 215. In addition, a middle dielectric isolation layer 125 is formed in the region vacated by the sacrificial silicon germanium layer 115a (see FIGS. 1B). The middle dielectric isolation spacers 120 and the middle dielectric isolation layer 125 may comprise nanopourous silica, hydrogensilsesquioxanes (HSQ), teflon-AF (polytetrafluoethylene or PTFE), silicon oxyflouride (FSG), silicon oxide, silicon oxynitride, silicon nitride, and/or silicon carbonitride in accordance with different embodiments of the disclosure. The middle dielectric isolation spacers 120 may be formed in the regions vacated by the sacrificial silicon germanium layers 115 (see FIGS. 1B) and then selectively etched to remove central portions thereof so that the middle dielectric isolation spacers 120 remain on opposite ends of opposing surfaces of each of the silicon channels 110. The etchant used may have an etching selectivity for the middle dielectric isolation spacers 120 relative to the silicon channels 110 and the silicon germanium layers 105. In accordance with different embodiments of the disclosure, the etching may be performed using a wet etching and/or a dry etching process.

In some embodiments, the stack including the alternating silicon channels 110 and silicon germanium layers 105 may be considered an upper stack for forming p-type transistors, the upper stack may be on a similarly constructed lower stack for forming n-type transistors, with both the upper and lower stacks being formed on a substrate. The substrate may include one or more semiconductor materials (e.g., Si, Ge, SiGe, GaP, GaAs, SiC, SiGeC and/or InP) and/or may include one or more insulating materials (e.g., silicon oxide, silicon oxynitride, silicon nitride, silicon carbonitride and/or a low-k material). Thus, in some embodiments, the middle dielectric isolation layer 125 may be used to separate the upper stack from a lower stack and/or a substrate.

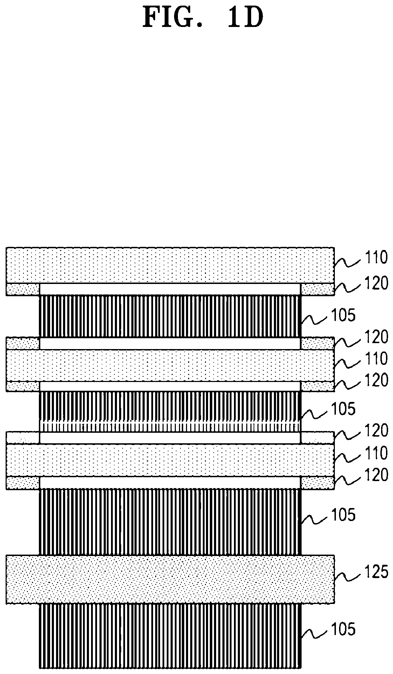

Referring to FIG. 1D, ends of the silicon germanium layers 105 may be etched to so that they are recessed from the ends of silicon channels 110 that are adjacent thereto. The etchant used may have an etching selectivity for the silicon germanium layers 105 relative to the silicon channels 110 and middle dielectric isolation spacers 120. In accordance with different embodiments of the disclosure, the etching may be performed using a wet etching and/or a dry etching process.

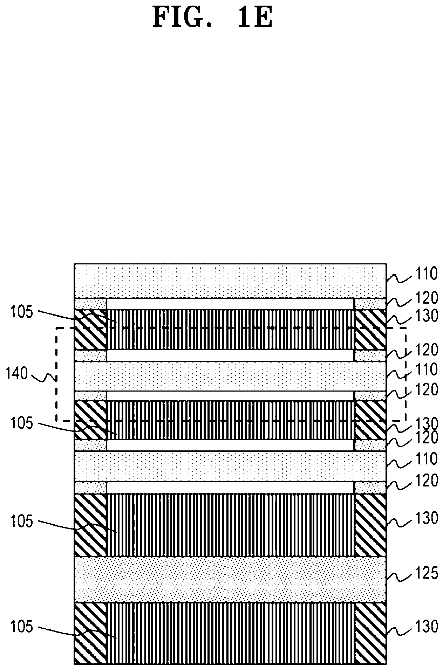

Referring to FIG. 1E and FIG. 2, inner spacers 130 are formed at block 220 between adjacent ones of the silicon channels 110 in the stack. The inner spacers 130 may comprise one or more insulating materials, such as silicon oxide, silicon oxynitride, silicon nitride, and/or silicon carbonitride. As shown in FIG. 1E, one of the silicon channels 110 and adjacent silicon germanium layers 105 are shown grouped as a combination 140 for forming a p-type field effect transistor.

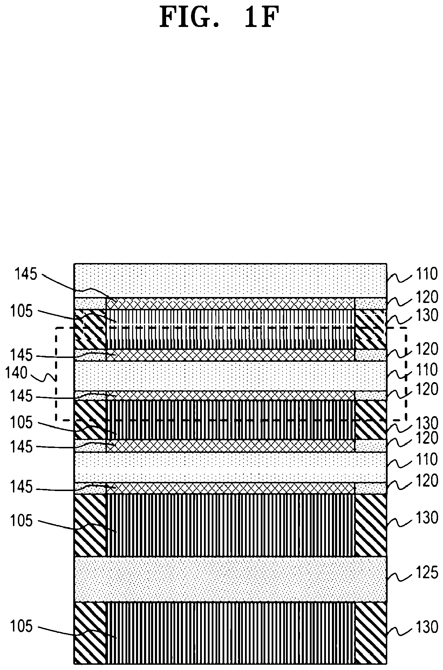

Referring to FIG. 1F and FIG. 2, silicon germanium is epitaxially grown on respective surfaces of each of the silicon germanium layers 105 adjacent to each of the silicon channels 110 at block 225. According to some embodiments, the silicon germanium layers 105 serve as the seed layers with the epitaxially grown material 145 being a continuation of the same silicon germanium compound. Thus, the epitaxial growth process may be referred to as a homoepitaxy process. The epitaxially grown material (silicon germanium layer) 145 may have the same crystallographic orientation as the silicon germanium layers 105. According to some embodiments, silicon germanium cladding layers can be epitaxially grown from sacrificial silicon germanium layers that are adjacent to the silicon channel. As shown in FIG. 1F, the epitaxially grown material 145 may abut the respective silicon channel 110 surfaces without being grown therefrom.

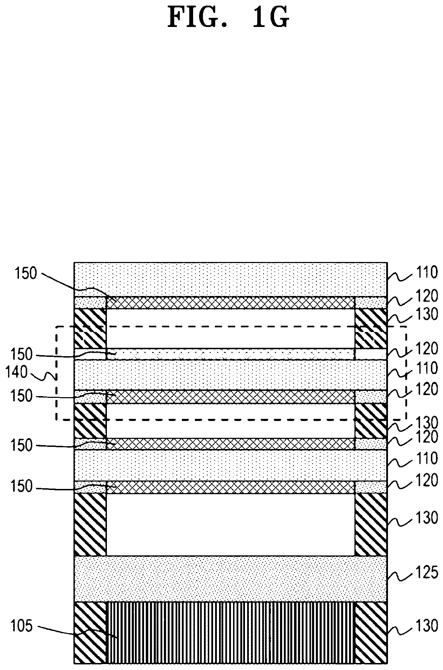

Referring to FIG. 1G and FIG. 2, portions of each of the silicon germanium layers 105 adjacent to the silicon channels 110 are selectively removed at block 230 to leave silicon germanium cladding layers 150 on opposing surfaces of the respective silicon channels 110 between the middle dielectric isolation spacers 120. The silicon germanium layers 105 may be selectively etched to remove central portions thereof so that the silicon germanium cladding layers 150 remain on opposing surfaces of each of the silicon channels 110. The etchant used may have an etching selectivity for the silicon germanium layers 105 relative to the silicon channels 110, the middle dielectric isolation spacers 120, and the inner spacers 130. In accordance with different embodiments of the disclosure, the etching may be performed using a wet etching and/or a dry etching process.

Thus, as shown in FIG. 1G, a p-type integrated circuit device, such as a p-type field effect transistor may be formed that includes a strained channel. The strained channel includes a silicon channel 110 and silicon germanium cladding layers 150 on opposing surfaces thereof where the silicon germanium cladding layers 150 abut the silicon channel 110 without being grown therefrom. Instead, the silicon germanium cladding layers 150 are grown using a homoepitaxy process from silicon germanium layers 105(see FIG. 1F) adjacent to the silicon channel 110.

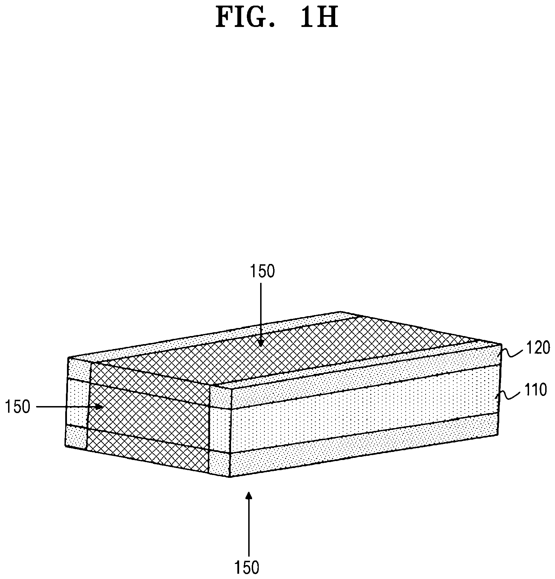

FIG. 1H is a perspective view of the silicon channel 110 with the silicon germanium cladding layers 150 formed thereon. In accordance with different embodiments, the silicon germanium cladding layers 150 may be formed on just a single pair of opposing sides of the silicon channel 110, e.g., upper and lower opposing surfaces of the silicon channel 110. In other embodiments, as shown in FIG. 1H, the silicon germanium cladding layers 150 may be formed on multiple pairs of opposing surfaces of the silicon channel 110, such as the top and bottom opposing surfaces and the front and back opposing surfaces. In such embodiments, the silicon germanium cladding layers 150 may form a wrap around the silicon channel 110.

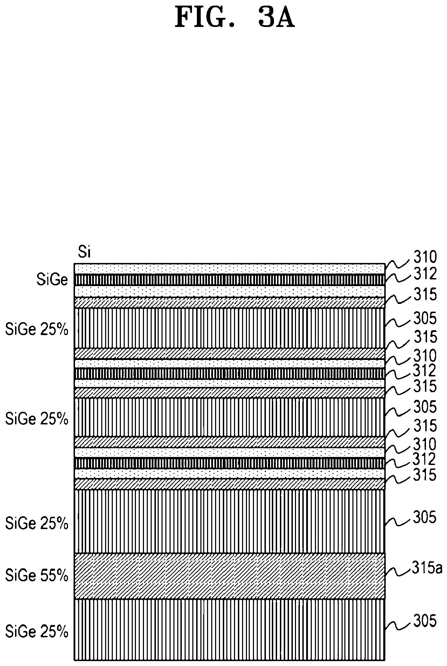

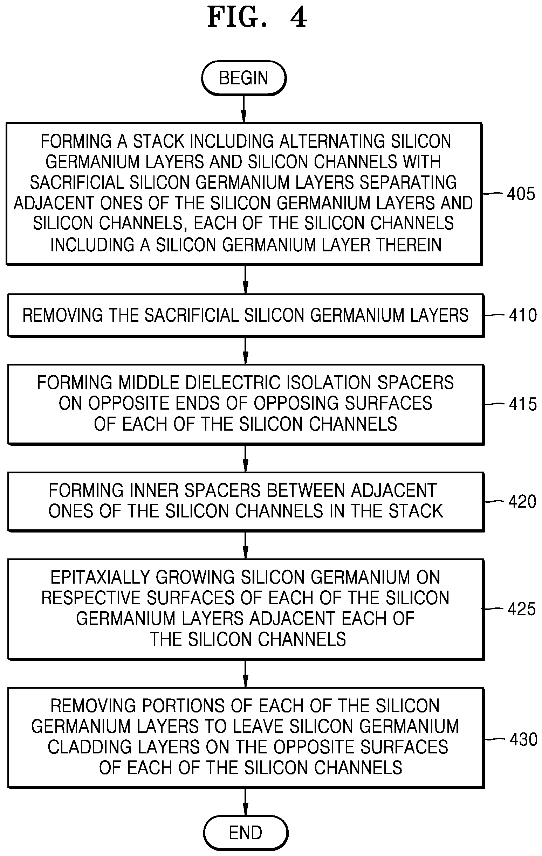

FIGS. 3A - 3G and FIG. 4 illustrate an integrated circuit device including a p-type field effect transistor (PFET) with a silicon germanium cladded channel and methods of forming the same according to some embodiments of the disclosure. Referring to FIGS. 3A and FIG. 4, operations begin at block 405 where a stack is formed including alternating silicon germanium layers 305 and silicon channels 310, with sacrificial silicon germanium layers 315 separating adjacent ones of the silicon germanium layers 305 from the silicon channels 310. Each of the silicon channels 310 includes a silicon germanium layer 312 therein. As described above, silicon germanium is compressively strained when on silicon. A strained silicon germanium channel can be used to increase hole mobility in PMOS devices. Thus, the silicon germanium layer 312 within the silicon channel 310 further improves carrier mobility in the silicon channel 310. In some embodiments, the percent composition of germanium in each of the silicon germanium layers 305 and 312 is greater than about 20%. In other embodiments, the percent composition of germanium in each of the silicon germanium layers 305 and 312 is about 25%. The sacrificial silicon germanium layers 315 may have a percent composition of germanium of about 55%. One of the sacrificial silicon germanium layers 315a may be between two of the silicon germanium layers 305.

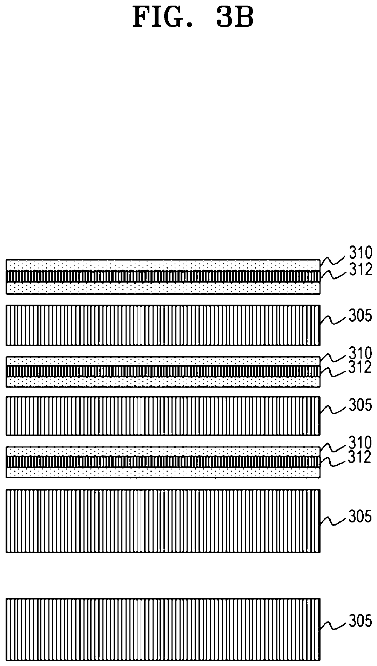

Referring to FIG. 3B and FIG. 4, the sacrificial silicon germanium layers 315 and 315a are selectively removed at block 410. The sacrificial silicon germanium layers 315 may be selectively removed using an etchant having an etching selectivity for the sacrificial silicon germanium layers 315 relative to the other silicon channels 310 and silicon germanium layers 305. In accordance with different embodiments of the disclosure, the etching may be performed using a wet etching and/or a dry etching process.

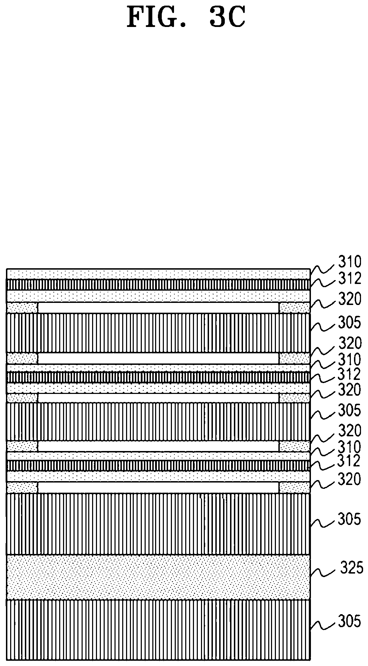

Referring to FIG. 3C and FIG. 4, middle dielectric isolation spacers 320 are formed on opposite ends of opposing surfaces of each of the silicon channels 310 at block 415. In addition, a middle dielectric isolation layer 325 in the region vacated by the sacrificial silicon germanium layer 315a (see FIG. 3B). The middle dielectric isolation spacers 320 and the middle dielectric isolation layer 325 may comprise nanopourous Silica, hydrogensilsesquioxanes (HSQ), teflon-AF (polytetrafluoethylene or PTFE), silicon oxyflouride (FSG), silicon oxide, silicon oxynitride, silicon nitride, and/or silicon carbonitride in accordance with different embodiments of the disclosure. The middle dielectric isolation spacers 320 may be formed in the regions vacated by the sacrificial silicon germanium layers 315(REF, FIG. 3B) and then selectively etched to remove central portions thereof so that the middle dielectric isolation spacers 320 remain on opposite ends of opposing surfaces of each of the silicon channels 310. The etchant used may have an etching selectivity for the middle dielectric isolation spacers 320 relative to the silicon channels 310 and the silicon germanium layers 305. In accordance with different embodiments of the disclosure, the etching may be performed using a wet etching and/or a dry etching process.

In some embodiments, the stack including the alternating silicon channels 310 and silicon germanium layers 305 may be considered an upper stack for forming p-type transistors, the upper stack may be on a similarly constructed lower stack for forming n-type transistors, with both the upper and lower stacks being formed on a substrate. The substrate may include one or more semiconductor materials (e.g., Si, Ge, SiGe, GaP, GaAs, SiC, SiGeC and/or InP) and/or may include one or more insulating materials (e.g., silicon oxide, silicon oxynitride, silicon nitride, silicon carbonitride and/or a low-k material). Thus, in some embodiments, the middle dielectric isolation layer 325 may be used to separate the upper stack from a lower stack and/or a substrate.

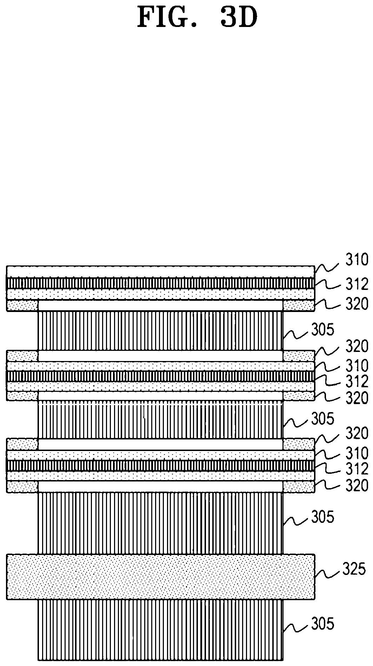

Referring to FIG. 3D, ends the silicon germanium layers 305 may be etched to so that they are recessed from the ends of silicon channels 310 that are adjacent thereto. The etchant used may have an etching selectivity for the silicon germanium layers 305 relative to the silicon channels 310 and middle dielectric isolation spacers 320. In accordance with different embodiments of the disclosure, the etching may be performed using a wet etching and/or a dry etching process.

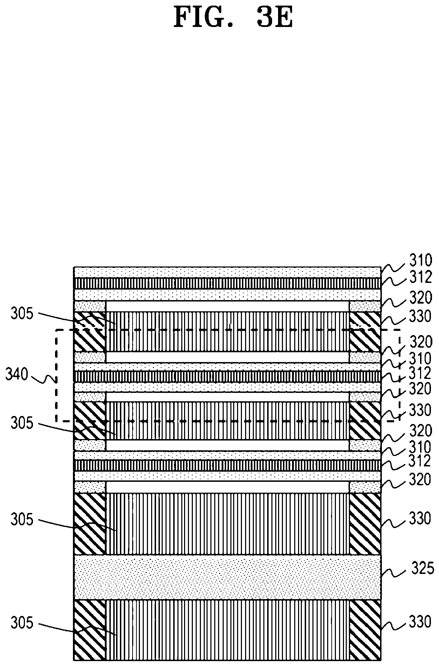

Referring to FIG. 3E and FIG. 4, inner spacers 330 are formed at block 420 between adjacent ones of the silicon channels 310 in the stack. The inner spacers 330 may comprise one or more insulating materials, such as silicon oxide, silicon oxynitride, silicon nitride, and/or silicon carbonitride. As shown in FIG. 3E, one of the channels 310 and adjacent silicon germanium layers 305 are shown grouped as a combination 340 for forming a p-type field effect transistor.

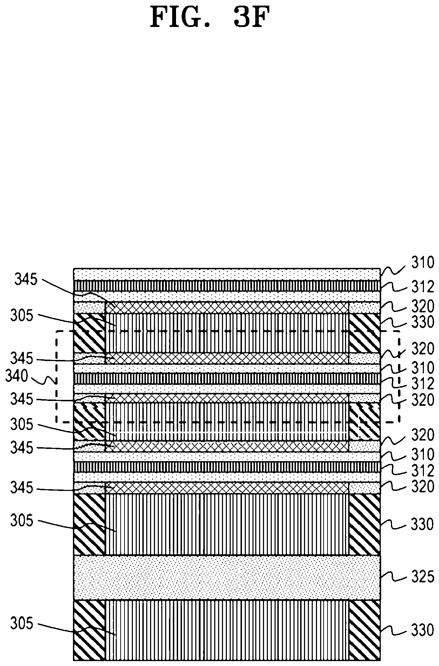

Referring to FIG. 3F and FIG. 4, silicon germanium is epitaxially grown on respective surfaces of each of the silicon germanium layers 305 adjacent to each of the silicon channels 310 at block 425. According to some embodiments, the silicon germanium layers 305 serve as the seed layers with the epitaxial growth 345 being a continuation of the same silicon germanium compound. Thus, the epitaxial growth process may be referred to as a homoepitaxy process. The epitaxial growth of the silicon germanium layer may have the same crystallographic orientation as the silicon germanium layers 305. According to some embodiments, silicon germanium cladding layers can be epitaxially grown from sacrificial silicon germanium layers that are adjacent to the silicon channel. As shown in FIG. 3F, the epitaxially grown material 345 may abut the respective silicon channel 310 surfaces without being grown therefrom.

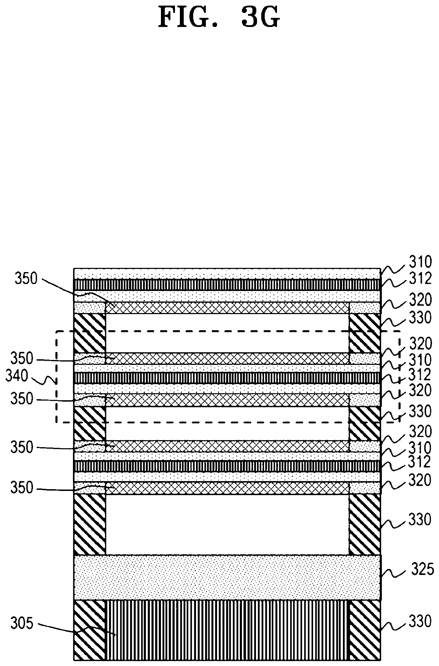

Referring to FIG. 3G and FIG. 4, portions of each of the silicon germanium layers 305 adjacent to the silicon channels 310 are selectively removed at block 430 to leave silicon germanium cladding layers 350 on opposing surfaces of the respective silicon channels 310 between the middle dielectric isolation spacers 320. The silicon germanium layers 305 may be selectively etched to remove central portions thereof so that the silicon germanium cladding layers 350 remain on opposing surfaces of each of the silicon channels 310. The etchant used may have an etching selectivity for the silicon germanium layers 305 relative to the silicon channels 310, the middle dielectric isolation spacers 320, and the inner spacers 330. In accordance with different embodiments of the disclosure, the etching may be performed using a wet etching and/or a dry etching process.

Thus, as shown in FIG. 3G, a p-type integrated circuit device, such as a p-type field effect transistor may be formed that includes a strained channel. The strained channel includes a silicon channel and silicon germanium cladding layers 350 on opposing surfaces thereof where the silicon germanium cladding layers 350 abut the silicon channel 310 without being grown therefrom. Instead, the silicon germanium cladding layers 350 are grown using a homoepitaxy process from silicon germanium layers 350 adjacent to the silicon channel 310.

Similar to the embodiments described above with respect to FIG. 1H, the silicon germanium cladding layers 350 may be formed on just a single pair of opposing sides of the silicon channel 310, e.g., upper and lower opposing surfaces of the silicon channel 310. In other embodiments the germanium cladding layers 350 may be formed on multiple pairs of opposing surfaces of the silicon channel 310, such as the top and bottom opposing surfaces and the front and back opposing surfaces. In such embodiments, the silicon germanium cladding layers 350 may form a wrap around the silicon channel 310.

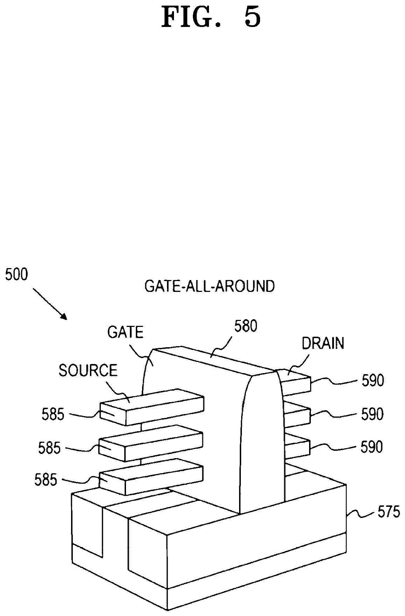

FIG. 5 is a perspective view of a gate all around finFET structure including multiple field effect transistors with strained channels, respectively, according to some embodiments of the disclosure. The finFET structure 500 is configured as a gate all around structure in which the gate borders (or covers) the channel on upper, lower, and sides of the channel. Multiple transistors, such as p-type field effective transistors, may be formed on the substrate 575 in the vertical finFET structure 500 with the transistors sharing a common gate 580 and each transistor including a source layer 585 and a drain layer 590. The source 585 and drain 590 layers may be respectively electrically coupled using a strained channel therebetween, which is controlled using a voltage applied to the gate 580. The strained channel may be embodied in accordance with any of the embodiments described above with respect to FIGS. 1A - 1G, FIG. 2, FIGS. 3A - 3G, and FIG. 4.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout the description. As used herein, the term "and/or" includes any and all combinations of one or more of the associated listed items. It is noted that aspects described with respect to one embodiment may be incorporated in different embodiments although not specifically described relative thereto. That is, all embodiments and/or features of any embodiments can be combined in any way and/or combination.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "connected" or "on," another element, it can be directly connected or on, the other element, or intervening elements may also be present. In contrast, when an element is referred to as being "directly connected" or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. An integrated circuit device, comprising:
a p-type field effect transistor that includes a strained channel, the strained channel comprising a silicon channel (110; 310) and silicon germanium cladding layers (150; 350) on opposing surfaces thereof, the silicon germanium cladding layers (150; 350) abutting the silicon channel (110; 310) without being grown therefrom.

2. The integrated circuit device of Claim 1, further comprising:
middle dielectric isolation spacers (120; 320) on opposite ends of each of the opposing surfaces of the silicon channel (110; 310);
wherein the silicon germanium cladding layers (150; 350) are between the middle dielectric isolation spacers (120; 320) on the opposing surfaces of the silicon channel (110; 310), respectively.

3. The integrated circuit device of Claim 2, wherein the middle dielectric isolation spacers comprise: nanopourous silica, hydrogensilsesquioxanes, HSQ, teflon-AF, polytetrafluoethylene or PTFE, silicon oxyflouride, FSG, silicon oxide, silicon oxynitride, silicon nitride, and/or silicon carbonitride.

4. The integrated circuit device of any one of Claims 1 to 3, wherein the silicon channel (310) includes a silicon germanium layer (312) therein.

5. The integrated circuit device of Claim 4, wherein a percent composition of the silicon germanium layer (312) in the silicon channel (310) is greater than 20%.

6. The integrated circuit device of any one of Claims 1 to 5, wherein the P-type field effect transistor is one of a plurality of P-type field effect transistors arranged in a stack, each of the plurality of P-type field effect transistors including the strained channel, the strained channel comprising the silicon channel (110; 310) and the silicon germanium cladding layers (150; 350) on the opposing surfaces thereof, the silicon germanium cladding layers (150; 350) abutting the silicon channels (110; 310) without being grown therefrom.

7. The integrated circuit device of Claim 6, further comprising:
middle dielectric isolation spacers (120; 320) on opposite ends of each of the opposing surfaces of each of the silicon channels (110; 310);
wherein the silicon germanium cladding layers (150; 350) are between the middle dielectric isolation spacers (120; 320) on the opposing surfaces, respectively, of each of the silicon channels (110; 310).

8. The integrated circuit device of Claim 7, further comprising:
inner spacers (130; 330) between adjacent ones of the silicon channels (110; 310) in the stack and that contact the middle dielectric isolation spacers (120; 320) on the respective ones of the silicon channels (110; 310).

9. The integrated circuit device of any one of Claims 6 to 8, further comprising:
a middle dielectric isolation layer (125; 325) that is between a substrate and the stack.

10. The integrated circuit device of Claim 9, wherein the middle dielectric isolation layer (125; 325) comprises:
nanopourous silica, hydrogensilsesquioxanes (HSQ), teflon-AF (polytetrafluoethylene or PTFE), silicon oxyflouride (FSG), silicon oxide, silicon oxynitride, silicon nitride, and/or silicon carbonitride.

11. The integrated circuit device of any one of Claims 1 to 10, wherein the silicon germanium cladding layers (150; 350) wrap around each silicon channel (110; 310).

12. A method of forming an integrated circuit device, comprising:
forming p-type field effect transistor stack comprising a pair of silicon germanium layers (105; 305) with a silicon channel (110; 310) therebetween, the silicon channel (110; 310) being spaced apart from the pair of silicon germanium layers (105; 305); and
epitaxially growing (S225; 425) silicon germanium on respective surfaces of each of the silicon germanium layers (105; 305) adjacent to the silicon channel (110; 310), such that each of the silicon germanium layers (105; 305) abuts the silicon channel (110; 310) on opposing surfaces thereof.

13. The method of Claim 12, further comprising:
removing (230; 430) portions of each of the silicon germanium layers (105; 305) to leave silicon germanium cladding layers (150; 350) on the opposing surfaces of the silicon channel, respectively.

14. The method of Claim 12 or 13, wherein forming the p-type field effect transistor stack comprises:
forming (S205; S405) a stack comprising alternating silicon germanium layers (105; 305) and silicon channels (110; 310) with sacrificial silicon germanium layers (115; 315) separating adjacent ones of the silicon germanium layers (105; 305) and silicon channels (110; 310), the alternating silicon germanium layers (105; 305) and silicon channels (110; 310) comprising the pair of silicon germanium layers (105; 305) and the silicon channel (110; 310); and
removing (S210; S410) the sacrificial silicon germanium layers (115; 315);
wherein each of the sacrificial silicon germanium layers (115; 315) has a percent composition of germanium of at least 55%.

15. The method of Claim 14, further comprising:
forming (S215) middle dielectric isolation spacers (130; 330) on opposite ends of each of the opposing surfaces of each of the silicon channels (110; 310);
wherein the middle dielectric isolation spacers (130; 330) comprise: nanopourous silica, hydrogensilsesquioxanes, HSQ, teflon-AF, polytetrafluoethylene or PTFE, silicon oxyflouride (FSG), silicon oxide, silicon oxynitride, silicon nitride, and/or silicon carbonitride.

16. The method of Claim 15, further comprising:
forming (S220; S420) inner spacers (130; 330) between adjacent ones of the silicon channels (110; 310) in the stack and that contact the middle dielectric isolation spacers (130; 330) on the respective ones of the silicon channels (110; 310);
wherein the inner spacers (130; 330) comprise silicon oxide, silicon oxynitride, silicon nitride, and/or silicon carbonitride.

17. The method of Claim 16, wherein epitaxially growing (S225; S425) the silicon germanium on the respective surfaces of each of the silicon germanium layers (105; 305), comprises:
epitaxially growing (S225; S425) silicon germanium (145; 345) on respective surfaces of each of the silicon germanium layers (105; 305) adjacent each of the silicon channels (110; 310), such that each of the silicon germanium layers abuts adjacent ones of the silicon channels (110; 310); and
removing portions of each of the silicon germanium layers (105; 305) to leave silicon germanium cladding layers (150; 350) on the opposing surfaces, respectively, of each of the silicon channels (110; 310);
wherein the silicon germanium cladding layers (150; 350) are between the middle dielectric isolation spacers (130; 330) on the opposing surfaces, respectively, of each of the silicon channels (110; 310).

18. The method of any one of Claims 14 to 17, wherein forming (S205; S305) the stack comprising the alternating silicon germanium layers (105; 305) and silicon channels (110; 310) with the sacrificial silicon germanium layers (115; 315) separating adjacent ones of the silicon germanium layers (105; 305) and silicon channels (110; 310), further comprises:
forming one of the sacrificial silicon germanium layers (115a; 315a) between the stack and a substrate.

19. The method of Claim 18, further comprising:
forming a middle dielectric isolation layer (125; 325) between stack and the substrate after removing the sacrificial silicon germanium layers (115a; 315a);
wherein the middle dielectric isolation layer (125; 325) comprises: nanopourous Silica, hydrogensilsesquioxanes (HSQ), teflon-AF (polytetrafluoethylene or PTFE), silicon oxyflouride (FSG). silicon oxide, silicon oxynitride, silicon nitride, and/or silicon carbonitride.

20. The method of any one of Claims 12 to 19, wherein each silicon channel includes a silicon germanium layer therein.
